(19) Europäisches Patentamt
European Patent Office
Office européen des brevets

(11) **EP 1 176 715 B1**

(12) **EUROPÄISCHE PATENTSCHRIFT**

(45) Veröffentlichungstag und Bekanntmachung des Hinweises auf die Patenterteilung:
**09.05.2007   Patentblatt 2007/19**

(51) Int Cl.:
***H03H 7/46*** *(2006.01)*

(21) Anmeldenummer: **01117990.0**

(22) Anmeldetag: **25.07.2001**

(54) **Verteileinheit für Hochfrequenz-Busleitungen**

Distributing unit for high frequency bus lines

Dispositif de distribution pour lignes de bus à hautes fréquences

(84) Benannte Vertragsstaaten:
**AT BE CH CY DE DK ES FI FR GB GR IE IT LI LU MC NL PT SE TR**

(30) Priorität: **28.07.2000   DE 10036823**

(43) Veröffentlichungstag der Anmeldung:
**30.01.2002   Patentblatt 2002/05**

(73) Patentinhaber: **Merten GmbH & Co. KG**
**51674 Wiehl (DE)**

(72) Erfinder:
• **Ludolf, Wilhelm S., Dr.-Ing.**
**72622 Nürtingen (DE)**

• **Kunert, Jürgen, Dipl.-Ing.**
**51702 Bergneustadt (DE)**

(74) Vertreter: **Selting, Günther et al**
**Patentanwälte**
**von Kreisler, Selting, Werner**
**Postfach 10 22 41**
**50462 Köln (DE)**

(56) Entgegenhaltungen:
**WO-A-95/27344          US-A- 5 321 372**

EP 1 176 715 B1

**Beschreibung**

Die Erfindung betrifft eine Verteileinheit für Hochfrequenz-Busleitungen und insbesondere eine Verteileinheit für Busleitungen in der Hausleittechnik, bei der die Busleitungen in einem Gebäude verlegt sind, um zwischen verschiedenen Teilnehmerstellen Signale zu übertragen.

Es ist bekannt, in Gebäuden Busleitungen zu verlegen, die ein Busleitungsnetz bilden und Teilnehmerstellen oder Anschlussstellen aufweisen, an die externe Geräte angeschlossen werden können. Die Geräte können über den Bus miteinander kommunizieren. Als Geräte können Computer, Haushaltsgeräte, Sensoren, Befehlsgeber u. dgl. angeschlossen werden. Die Anschlussstellen sind im Gebäude wenn möglich in Unterputzdosen untergebracht. Die Busleitungen selbst sind in der Regel unter Putz verlegt.

Die Anschlussstellen befinden sich entweder am Ende einer Stichleitung, oder es muss eine Abzweigung vom Bus vorgesehen werden. Der Bus besteht aus einer Leitung aus zwei miteinander verdrillten symmetrischen Adern (twisted pair). Eine ähnliche Anordnung ist beispielsweise aus der WO/95/27344 A1 bekannt.

Wenn ein Bus Hochfrequenzsignale bis hin zum Megahertzbereich übertragen soll, spielen die Abschlusswiderstände eine große Rolle. Die Busleitung hat üblicherweise eine Leitungsimpedanz $Z_L$ von etwa 70 - 200 $\Omega$. Eine Hochfrequenzleitung ist dann ordnungsgemäß angepasst, wenn sie mit einem Widerstand abgeschlossen ist, der gleich dem Wellenwiderstand der Hochfrequenzleitung ist. Ist diese Bedingung nicht erfüllt, dann treten an der Abschluss- oder Verzweigungsstelle Reflektionen auf, wobei das Hochfrequenzsignal reflektiert wird. Durch reflektierte Signale kann der Busbetrieb empfindlich gestört werden, da die an den Bus angeschlossenen Teilnehmer dann vermuten, dass der Bus anderweitig belegt ist und das Aussenden von Signalen vorübergehend einstellen.

Eine weitere Besonderheit von Datenbussystemen in der Hausleittechnik besteht darin, dass der Datenbus nicht nur Signale überträgt, sondern auch die Versorgungsspannung für aktive Schaltungen, die im Bereich des Bussystems installiert sind, beispielsweise Schnittstellen, die Mikroprozessoren enthalten.

Der Erfindung liegt die Aufgabe zugrunde, eine Verteileinheit für zweiadrige symmetrische Hochfrequenz-Busleitungen zu schaffen, die durch Realisierung geeigneter Übergangswiderstände einen angepassten Abschluss der ankommenden Busleitungen und der abgehenden Busleitungen ermöglicht und gleichzeitig eine nahezu verlustfreie Weiterleitung der Versorgungsspannung auf alle Busleitungen gewährleistet.

Die Lösung dieser Aufgabe erfolgt erfindungsgemäß mit den im Patentanspruch 1 angegebenen Merkmalen. Hiernach weist die Verteileinheit als zentrales Element einen passiven symmetrischen Hochfrequenz-Leistungsteiler auf. Der Leistungsteiler ist mit mehreren Anschlusseinheiten verbunden, von denen jede eine Frequenzweiche enthält. Die Frequenzweiche teilt die vom ankommenden Bus gelieferte Spannung in einen Versorgungsteil und einen Hochfrequenzteil auf. Der Hochfrequenzteil wird dem zentralen Leistungsteiler zugeführt und der Versorgungsteil wird über eine separate Gleichspannungsleitung den Versorgungszweigen der übrigen Frequenzweichen zugeführt. Dadurch ist sichergestellt, dass der Hochfrequenz-Leistungsteiler nur mit dem Hochfrequenzanteil beaufschlagt wird. Der Leistungsteiler kann daher entsprechend dem Wellenwiderstand der angeschlossenen Busleitungen dimensioniert sein, so dass jede dieser Busleitungen bezogen auf den Leistungsteiler denselben Widerstand sieht, der dem Wellenwiderstand entspricht. Der Leistungsteiler enthält normalerweise eine Kombination von Widerständen, vorzugsweise in einer doppelsternförmigen Anordnung. Wenn einem derartigen Leistungsteiler die Versorgungsspannung zugeführt würde, würde ein hoher Teil der Versorgungsspannung im Leistungsteiler in Verlustwärme umgesetzt. Dies wird erfindungsgemäß dadurch vermieden, dass die Versorgungsspannung um den Leistungsteiler herum umgeleitet und direkt von Frequenzweiche zu Frequenzweiche übertragen wird.

Die erfindungsgemäße Verteileinheit ermöglicht einen dem Wellenwiderstand entsprechenden angepassten Abschluss einer zweiadrigen symmetrischen Busleitung. Dadurch besteht die Möglichkeit, höherfrequente Signale über die Busleitung zu transportieren und mit Hilfe der Busleitung auch über Verzweigungsstellen hinweg zu übertragen, ohne dass störende Reflektionen auftreten. Die Übertragungsfrequenz von zweiadrigen symmetrischen Busleitungen in der Gebäudesystemtechnik oder Hausleittechnik liegen bisher im Kilohertzbereich. Mit der erfindungsgemäßen Verteileinheit können sie weit in den Megahertzbereich hinein erhöht werden. Es ist damit möglich, über eine derartige Busleitung auch beispielsweise Videosignale von einem Sender zu einem Empfänger zu übertragen.

An einer Verzweigungsstelle einer Busleitung müssen die Abzweigungen mit dem Wellenwiderstand abgeschlossen sein, damit eine Hochfrequenzanpassung vorliegt, und keine Reflexionen auftreten. Bei solchen Abzweigstellen, die in einer Hausinstallation verlegt werden, kann es vorkommen, dass nicht benötigte Abzweige offengelassen werden, d. h., dass an diese Abzweige nichts angeschlossen wird. Dann bewirkt der Hochfrequenz-Leistungsteiler nicht mehr die geplante Anpassung an den Wellenwiderstand und es entstehen Reflektionen.

Um solche Fehlanpassungen automatisch zu vermeiden, ist in vorteilhafter Weiterbildung der Erfindung vorgesehen, dass mindestens eine Anschlusseinheit einen Leitungsfehlabschlusssensor aufweist, der anhand von Betrag und Richtung des durch den Versorgungszweig fließenden Stroms einen Fehlabschluss einer Anschlusseinheit feststellt und daraufhin die beiden dieser Anschlusseinheit entsprechenden Adern des Hochfrequenz-Leistungsteilers von der Frequenzweiche trennt und sie mit der wellenwiderstandsrichtigen Abschlussimpedanz verbindet. Auf diese Weise wird durch eine Stromstärkemessung nach Betrag und Richtung festgestellt, ob die betreffende Anschlusseinheit einschließlich der weiterführenden Busleitungen den erforderlichen elektrischen Widerstand hat. Wenn eine weiterführende Busleitung nicht vorhanden ist und auch nicht durch einen Abschlusswiderstand ersetzt ist, ist der resultierende Leitungswiderstand zu groß und der fließende Strom zu klein oder Null. Dieser Fall wird durch den Leitungsfehlabschlusssensor erkannt und dieser bewirkt dann das Anschalten einer Abschlussimpedanz an den Hochfrequenz-Leistungsteiler. Dadurch wird im Falle, dass ein Abzweig der Verteilereinheit nicht ordnungsgemäß beschaltet ist, ein angepasster Betrieb des Leistungsteilers bewirkt, so dass die Signalübertragung auf den angeschlossenen Busleitungen in angepasstem Zustand reflexionsfrei erfolgt. Im Falle eines Kurzschlusses der weiterführenden Leitung ist der fließende Strom zu groß. Dieser Fehlabschluss wird ebenfalls erkannt, die Leitung wird abgetrennt und der Hochfrequenzleistungsteiler wellenwiderstandsrichtig abgeschlossen. Wenn der Leitungsfehlabschlusssensor einen Strom mit Richtung in die Verteileinrichtung detektiert, folgt daraus, dass weitere Geräte an der Verteileinheit angeschlossen sind, die gleichzeitig die Spannungsversorgung der betreffenden Verteileinrichtung mit übernehmen. In diesem Fall darf die Zwangsabkopplung nicht erfolgen. Diese Aspekte der vorliegenden Erfindung machen irrtümliche Falschinstallationen der Verteileinheit durch fehlerhafte Beschaltung der Anschlusseinheiten unschädlich.

Im Folgenden wird unter Bezugnahme auf die Zeichnungen ein Ausführungsbeispiel der Erfindung näher erläutert.

Es zeigen:

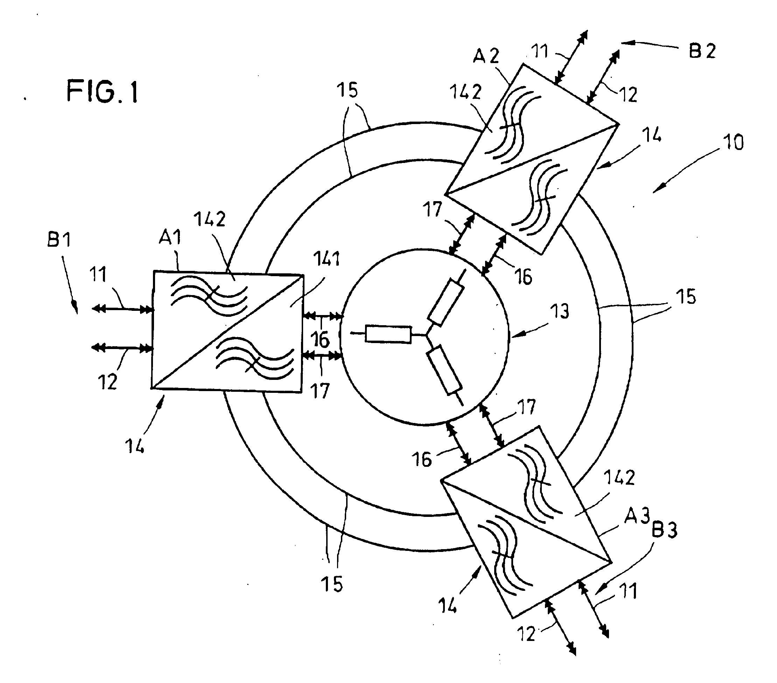

Fig. 1 ein schematisches Blockschaltbild der Verteileinheit für zweiadrige symmetrische Hochfrequenz-Busleitungen,

Fig. 2 eine detailliertere Darstellung der Verteileinheit von Fig. 1 und

Fig. 3 eine Darstellung einer Ausführungsform des Hochfrequenz-Leistungsteilers.

Die dargestellte Verteileinheit dient zum Verbinden von drei Datenbussen B1, B2, B3. Jeder Datenbus weist zwei in Bezug auf Erd- oder Massepotential symmetrische Adern 11, 12 auf, die jeweils isoliert und miteinander verdrillt sind (twisted pair-Leitungen). Jeder Datenbus kann bidirektional Daten übertragen. Die gesamte Verteileinheit 10 ist in einer üblichen Unterputzdose angeordnet, wie sie in der Installationstechnik für Netzspannungen üblich ist. Die Busleitungen B1, B2, B3 sind in einem Gebäude verlegt. Über jeden Datenbus wird außer Datensignalen auch eine Gleichspannung als Versorgungsspannung für an den Datenbus angeschlossene elektronische Einrichtungen übertragen.

Die Verteileinheit weist einen zentralen symmetrischen Hochfrequenz-Leistungsteiler 13 auf, der hier als Doppel-Sternschaltung ausgebildet ist und drei Anschlüsse hat.

Jeder Datenbus B1, B2, B3 ist an eine eigene Anschlusseinheit A1, A2 bzw. A3 angeschlossen. Die Anschlusseinheit enthält eine Frequenzweiche 14 mit einem Hochfrequenzzweig 141 und einem Versorgungsspannungszweig 142. Der Hochfrequenzzweig 141 besteht aus einem Hochpass und der Versorgungsspannungszweig 142 aus einem Tiefpass. Die Frequenzweiche separiert also die Hochfrequenz von der Versorgungsspannung, die eine Gleichspannung oder eine niederfrequente Wechselspannung ist. Als Frequenzweiche kann eine Drossel (als Tiefpass) und ein Kondensator (als Hochpass) benutzt werden. Die Versorgungsspannungszweige 142 der Frequenzweichen 14 sind miteinander durch Versorgungsspannungsleitungen 15 verbunden. Wenn die Versorgungsspannung beispielsweise auf dem Bus B1 zugeführt wird, wird sie von dem Versorgungsspannungszweig 142 der Anschlusseinheit A1 auf die Versorgungsspannungszweige der beiden übrigen Anschlusseinheiten A2 und A3 übertragen und sie gelangt von dort auf die Busleitungen B2 und B3. Wenn die Versorgungsspannung eine Gleichspannung ist, wird sie nahezu verlustlos durch die Verteileinheit transportiert.

Die Hochfrequenz wird über zwei Adern 16, 17 zwischen dem jeweiligen Hochfrequenzzweig 141 und dem Hochfrequenz-Leistungsteiler 13 übertragen. Der Hochfrequenz-Leistungsteiler bildet für den Hochfrequenzteil eines jeden Datenbusses einen angepassten Abschluss.

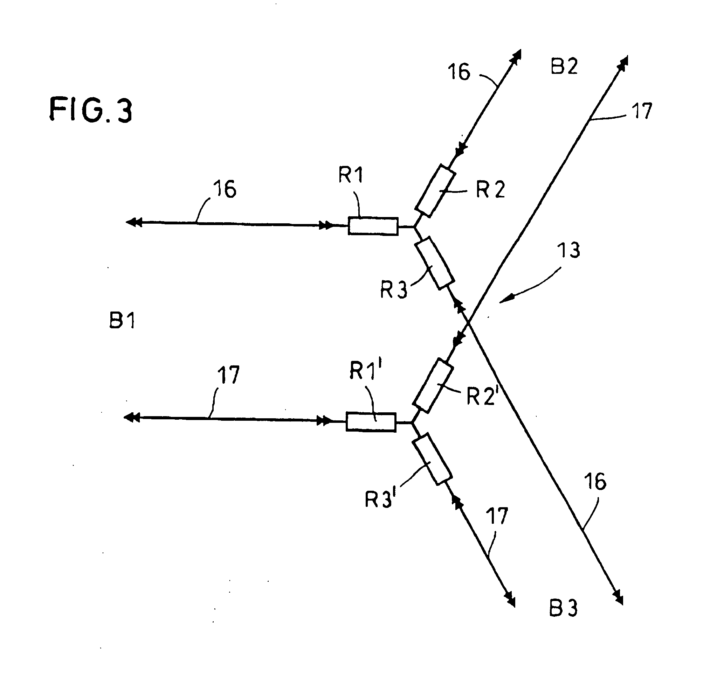

Es sei angenommen, dass der Wellenwiderstand $Z_L$ der Datenbusse jeweils 70 Ω beträgt. Fig. 3 zeigt den Aufbau des Hochfrequenz-Leistungsteilers 13, der aus zwei Widerstands-Sternschaltungen besteht. Die erste Sternschaltung enthält die ohmschen Widerstände R1, R2, R3 und die zweite Sternschaltung enthält die ohmschen Widerstände R1', R2', R3'. Die Beine der Sternschaltung aus den Widerständen R1, R2, R3 sind jeweils mit der der Ader 16 betreffenden Anschlusseinheit verbunden und die Beine der aus den Widerständen R1', R2', R3' bestehenden Sternschaltung sind mit der Ader 17 verbunden. Die Adern 16, 17 sind (über die jeweilige Frequenzweiche 14) mit dem zugehörigen Datenbus verbunden. Bei einem symmetrischen Hochfrequenz-Leistungsteiler mit n Anschlüssen ergibt sich eine Leistungsanpassung, wenn die folgende Bedingung erfüllt ist:

$$R = \frac{n-2}{2n} \cdot Z_L$$

Hierin ist R die Größe jedes der Widerstände der beiden Sternschaltungen und n die Anzahl der Anschlüsse. Wenn n, wie bei dem in Fig. 3 dargestellten Beispiel, drei ist, ergibt sich für jeden der Widerstände R1, R2, R3 und R1', R2', R3' eine Größe von $1/6\ Z_L$, wobei $Z_L$ der Wellenwiderstand der Busleitungen ist. Bei einer derartigen Bemessung der Widerstände sieht jede Busleitung, die in die Verteileinheit hineinführt, einen Widerstand der gleich dem Wellenwiderstand $Z_L$ dieser Busleitung ist, unter der Voraussetzung, dass an die beiden anderen Anschlüsse ebenfalls Busleitungen angeschlossen sind, die hochfrequenzmäßig angepasst sind.

Als Hochfrequenz-Leistungsteiler 13 kann alternativ auch eine aktive Matrix oder ein Koppelfeld benutzt werden.

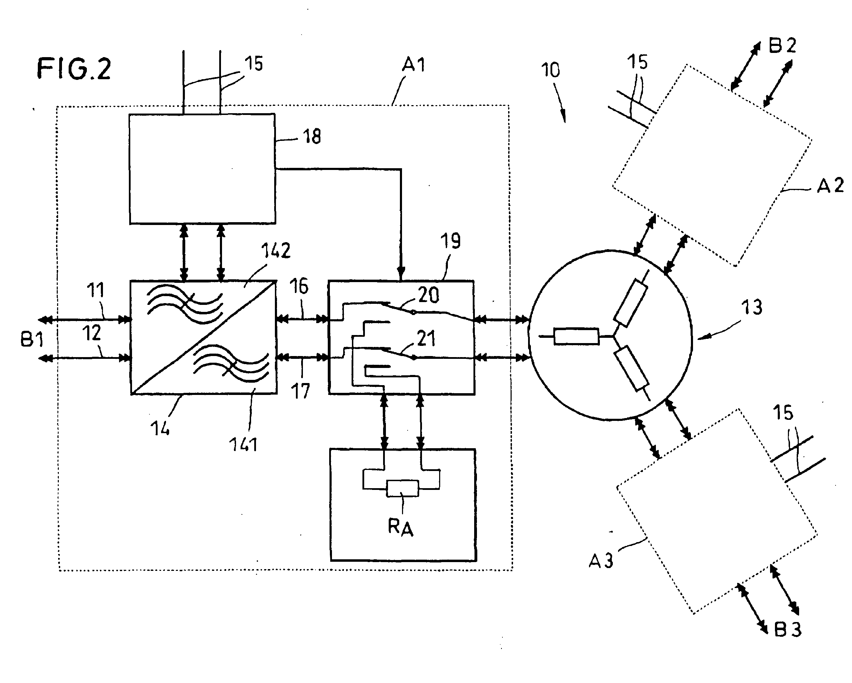

Fig. 2 zeigt detaillierter den Aufbau der Anschlusseinheit A1. Die übrigen Anschlusseinheiten A2 und A3 sind in gleicher Weise aufgebaut. Der Versorgungsspannungszweig 142 der Frequenzweiche 14 ist an einen Leitungsfehlabschlusssensor 18 angeschlossen, der den in der Versorgungsspannungsleitung 15 fließenden Strom misst und dadurch feststellt, ob die Anschlusseinheit A1 mit einem entsprechenden Bus B1 ordnungsgemäß abgeschlossen ist. Wenn beispielsweise der Bus B1 nicht angeschlossen ist, ist der entsprechende Anschluss hochohmig, so dass der durch die speisende Versorgungsspannungsleitung 15 aus der Anschlusseinheit A1 fließende Strom Null wird oder einen vorgegebenen Grenzwert unterschreitet. Diese Unterschreitung des Grenzwerts wird durch den Leitungsfehlabschlusssensor 18 detektiert und dieser liefert ein Fehlabschluss-Signal an eine Schalteinrichtung 19, welche zwei Schalter 20, 21 enthält. Der Schalter 20 ist in die von der Frequenzweiche 14 zum Hochfrequenz-Leistungsteiler 13 führende Ader 16 geschaltet und der Schalter 21 in die hierzu parallel verlaufende Ader 17. Im Ruhezustand befinden sich die Schalter 20, 21 in der dargestellten Position, in der sie die Adern 16 und 17 durchverbinden, d. h. den Hochfrequenzzweig der Frequenzweiche 14 mit dem Hochfrequenz-Leistungsteiler 13 verbinden. Wenn jedoch in einer Anschlusseinheit ein Fehlabschluss festgestellt wird, werden die Schalter 20, 21 dieser Anschlusseinheit umgeschaltet, so dass sie dann die Adern 16 und 17 mit einer Abschlussimpedanz $R_A$ verbinden und von der Frequenzweiche 14 trennen. Auf diese Weise wird ein Zwangsabschluss des betreffenden Anschlusses des Hochfrequenz-Leistungsteilers 13 durch die Abschlussimpedanz $R_A$ durchgeführt. Dies ist beispielsweise dann der Fall, wenn an eine der Anschlusseinheiten kein Bus angeschlossen ist.

Im Falle eines Kurzschlusses erkennt der Leitungsfehlabschlusssensor 18 einen zu hohen Stromfluss (aus der Verteileinrichtung 10 heraus); er trennt den Hochfrequenzleistungsverteiler 13 von der entsprechenden Busleitung B1, B2, B3 und ersetzt diese Leitung durch den entsprechenden Abschlusswiderstand RA, so dass der Hochfrequenzleistungsverteiler 13 wellenwiderstandsrichtig abgeschlossen ist und somit keine Reflexionen auftreten können. Wenn ein Strom in die Verteileinrichtung 10 hinein detektiert wird, wird die entsprechende Busleitung B1, B2, B3 auf den Hochfrequenzleistungsverteiler 13 durchgeschaltet.

**Patentansprüche**

1. Verteileinheit für zweiadrige symmetrische Hochfrequenz-Busleitungen, mit mehr als zwei Anschlusseinheiten (A1, A2, A3), die mit einem Hochfrequenz-Leistungsteiler (13) verbunden sind, **dadurch gekennzeichnet, daß** jede Anschlusseinheit (A1, A2, A3) eine Frequenzweiche (14) enthält, die einen Versorgungsspannungszweig (142) und einen zu dem Hochfrequenz-Leistungsteiler (13) führenden Hochfrequenzzweig (141) aufweist, und die Versorgungsspannungszweige (142) der Frequenzweichen (14) durch Versorgungsspannungsleitungen (15) verbunden sind.

2. Verteileinheit nach Anspruch 1, **dadurch gekennzeichnet, dass** mindestens eine Anschlusseinheit (A1, A2, A3) einen Leitungsfehlabschlusssensor (18) aufweist, der anhand der Stärke des durch den Versorgungszweig (142) fließenden Stroms einen Fehlabschluss einer Anschlusseinheit feststellt und daraufhin die beiden dieser Anschlusseinheit entsprechenden Adern des Hochfrequenz-Leistungsteilers (13) von der Frequenzweiche (14) trennt und durch eine Abschlussimpedanz ($R_A$) verbindet.

3. Verteileinheit nach Anspruch 1 oder 2, **dadurch gekennzeichnet, dass** der Hochfrequenz-Leistungsteiler (13) zwei Sternschaltungen von Widerständen (R1, R2, R3; R1', R2', R3') enthält.

4. Verteileinheit nach einem der Ansprüche 1 - 3, **dadurch gekennzeichnet, dass** der Leitungsfehlabschlusssensor (18) eine Schwellenwertschaltung enthält, die ein Signal erzeugt, wenn der im Versorgungszweig (142) fließende Strom einen ersten Grenzwert unterschreitet oder einen zweiten Grenzwert überschreitet.

5. Verteileinheit nach einem der Ansprüche 2 - 4, **dadurch gekennzeichnet, dass** der Leitungsfehlabschlusssensor (18) eine Stromrichtungserkennung enthält, die ein Frei-Signal erzeugt, wenn der im Versorgungsspannungszweig (142) fließende Strom in die Verteileinrichtung (10) hineinfließt.

**Claims**

1.  A distributing unit for two-wire symmetric high-frequency bus lines, comprising more than two connection units (A1,A2,A3) connected to a high-frequency power divider (13),
    **characterized in that** each connection unit (A1,A2,A3) includes a selector (14) comprising a voltage supply branch (142) and a high-frequency branch (141) leading to the high-frequency power divider (13), and that the supply voltage branches (142) of the selectors (14) are connected to each other by voltage supply lines (15).

2.  The distributing unit according to claim 1, **characterized in that** at least one connection unit (A1,A2,A3) comprises a line termination fault sensor (18) operative to detect a termination fault of a connection unit on the basis of the level of the current flowing through the supply branch (142) and, thereupon, to separate from the selector (14) the two wires of the high-frequency power divider (13) corresponding to this connection unit, and to connect these two wires by a termination impedance ($R_A$).

3.  The distributing unit according to claim 1 or 2, **characterized in that** the high-frequency power divider (13) includes two star configurations of resistors (R1; R2,R3; R1';R2',R3').

4.  The distributing unit according to any one of claims 1 - 3, **characterized in that** the line termination fault sensor (18) includes a threshold circuit operative to generate a signal when the current flowing in the supply branch (142) drops below a first threshold value or rises above a second threshold value.

5.  The distributing unit according to any one of claims 2 - 4, **characterized in that** the line termination fault sensor (18) includes a current direction detector operative to generate a clear signal when the current flowing in the supply branch (142) flows into the distributing means (10).

**Revendications**

1.  Unité de distribution pour des bus haute fréquence symétriques à deux conducteurs, comportant plus de deux unités de raccordement (A1, A2, A3) qui sont reliées à un diviseur de puissance haute fréquence (13), **caractérisée en ce que** chaque unité de raccordement (A1, A2, A3) renferme un circuit diviseur de fréquence (14), qui présente une branche (142) pour la tension d'alimentation et une branche haute fréquence (141) menant au diviseur de puissance haute fréquence (13), et les branches (142) pour la tension d'alimentation des circuits diviseurs de fréquence (14) sont reliées par des lignes (15) de fourniture de la tension d'alimentation.

2.  Unité de distribution selon la revendication 1, **caractérisée en ce qu'**au moins une unité de raccordement (A1, A2, A3) présente un détecteur de terminaison défectueuse de ligne (18) qui, sur la base de l'intensité du courant circulant à travers la branche d'alimentation (142), relève une terminaison défectueuse d'une unité de raccordement et, à la suite de cela, sépare du circuit diviseur de fréquence (14) les deux conducteurs, correspondant à cette unité de raccordement, du diviseur de puissance haute fréquence (13) et les relie par une impédance terminale ($R_A$).

3.  Unité de distribution selon la revendication 1 ou 2, **caractérisée en ce que** le diviseur de puissance haute fréquence (13) comprend deux montages en étoile de résistances (R1, R2, R3 ; R1', R2', R3').

4.  Unité de distribution selon l'une des revendications 1 à 3, **caractérisée en ce que** le détecteur de terminaison défectueuse de ligne (18) comprend un circuit à seuil, qui engendre un signal lorsque le courant circulant dans la branche d'alimentation (142) tombe en dessous d'une première valeur limite ou dépasse une deuxième valeur limite.

5.  Unité de distribution selon l'une des revendications 2 à 4, **caractérisée en ce que** le détecteur de terminaison défectueuse de ligne (18) comprend un moyen de reconnaissance du sens du courant, qui engendre un signal exempt lorsque le courant circulant dans la branche (142) pour la tension d'alimentation arrive dans le dispositif de distribution (10).

FIG.1

EP 1 176 715 B1

FIG.2

FIG.3

EP 1 176 715 B1